# EUROPÄISCHE PATENTSCHRIFT

(11) **EP 1 020 732 B1**
(45) Veröffentlichungstag und Bekanntmachung des Hinweises auf die Patenterteilung: **12.03.2008**
(21) Anmeldenummer: 00100915.8
(22) Anmeldetag: 18.01.2000
(51) Int. Cl.: G01R 31/307, G01R 31/311, G01N 23/225, H01L 21/66

(54) **Verfahren und Vorrichtung zum Testen der Funktion einer Vielzahl von aktiven Mikrostrukturbauelementen**
Procedure and apparatus for testing the function of a multitude of active microstructure elements
Procédé et appareil de test du fonctionnement d'une pluralité d'elements microstructurels actifs

(30) Priorität: 18.01.1999 DE 19901767
(43) Veröffentlichungstag der Anmeldung: 19.07.2000
(73) Patentinhaber: ETEC EBT GmbH, 85622 Feldkirchen (DE)
(72) Erfinder: Brunner, Matthias, Dr., 85551 Kirchheim (DE); Schmid, Ralf, Dr., 85586 Poing (DE)
(74) Vertreter: Zimmermann & Partner

(56) Entgegenhaltungen:
- US-A- 4 695 794
- US-A- 4 875 004
- US-A- 5 057 773
- US-A- 5 258 706
- US-A- 5 663 967
- US-A- 5 825 191

## Beschreibung

Die Erfindung betrifft ein Verfahren sowie eine Vorrichtung zum Testen der Funktion einer Vielzahl von aktiven Mikrostrukturbauelementen.

Unter aktiven Mikrostrukturbauelementen versteht man beispielsweise Elemente der Mikroelektronik (wie Transistoren, Dioden, Metall-Isolator-Metallelemente), Bildpunktelemente und Displays, Elektrodenstrukturen mikromechanischer Sensoren und Aktoren sowie Korpuskularstrahlung (beispielsweise Licht oder Elektroden) emittierende Elemente, wie Laserdioden oder Feldemissionsspitzen.

Derartige Mikrostrukturbauelemente werden jeweils in einer Vielzahl auf einem Substrat, beispielsweise Wafern oder Glasplatten, hergestellt. In der Mikrostrukturtechnik werden mechanische, optische, elektrische und andere Bauelemente mit Verfahren und Prozessen hergestellt, die in der Mikroelektronik bereits lange bekannt sind. Dementsprechend treten auch die bekannten Fehler bei der Herstellung auf, die beispielsweise durch Verschmutzungen oder Fehljustagen verursacht werden. Um eine einwandfreie Funktion der Mikrostrukturbauelemente gewährleisten zu können, ist es daher erforderlich, die Funktion jedes einzelnen Elements zu testen. Der Test von Mikrostrukturbauelementen stellt jedoch durch die kleinen Dimensionen besondere Anforderungen an das verwendete Verfahren und die entsprechende Vorrichtung.

Mikrostrukturbauelemente der Mikroelektronik werden üblicherweise auf dem Wafer dadurch getestet, daß Proberspitzen die einzelnen Bauelemente (Chips) kontaktieren und diese einer Sequenz elektrischer Prüfungen unterwerfen. Kontaktlose Verfahren unter Benutzung von Korpuskularstrahlen sind durch die schnelle Messung der elektrischen Funktionen von Transistoren, Leitungen sowie von Kapazitäten und Widerständen beispielsweise aus der US-A-3,531,716 bekannt. Diese bekannten Verfahren beruhen im wesentlichen darauf, daß mit Hilfe eines Elektronenstrahls die elektrische Ladung an einer bestimmten Stelle des Bauteils mittels ausgelöster Sekundärelektronen gemessen wird.

Ein Verfahren gemäß dem Oberbegriff des Anspruches 1 ist beispielsweise aus der EP-B-0 523 594 bekannt, bei dem die Funktion von Elementen in Flüssigkristalldisplays geprüft wird. Dieses Verfahren benutzt einen Korpuskularstrahl, bevorzugt einen Elektronenstrahl, sowohl zur Ladungsmessung als auch zur Stromeinspeisung in die Displayelemente.

Alle bekannten kontaktlosen Verfahren detektieren jedoch fehlerfreie Elemente als fehlerhaft, wenn die Fehlerschwellen für die Auswertung zu nahe an die Sollwerte der Meßsignale gesetzt werden. Andererseits werden eventuell Fehler nicht detektiert, wenn ein hinreichender Abstand zwischen Sollwerten und Schwellwerten eingestellt wird. Darüber hinaus stehen für Fehlerklassifizierungen nur Ergebnisdaten in sehr begrenztem Umfang durch die herkömmlichen Tests zur Verfügung

Aus der US-A-5 258 706 ist ein Verfahren zum Feststellen von Fehlern bei Netzwerken bekannt, bei dem ein in einem Haupttest aufgefundener Fehler in einem Nachtest nochmals bestätigt wird.

Die US-A-5 663 967 beschreibt ein Verfahren und eine Vorrichtung zum Auffinden von Fehlern in integrierten Schaltungen, die die benötigte Zeit und den Aufwand zur exakten Lokalisation der Fehler reduzieren. Dabei werden die Schaltung mit Testvektoren beaufschlagt und die Ausgangssignale auf Fehler überprüft. Durch geeignete Fehlervektoren kann der fehlerhafte Bereich der Schaltung eingegrenzt werden. Zur exakten Bestimmung des Fehlerortes kann schließlich ein Elektronenstrahl eingesetzt werden.

Der Erfindung liegt daher die Aufgabe zugrunde, ein Verfahren sowie eine Vorrichtung zum Testen der Funktion von Mikrostrukturbauelementen unter Benutzung von Korpuskularstrahlen sowie ein Verfahren zur Herstellung von Mikrostrukturbauelementen anzugeben, wobei eine genauere Fehlerabgrenzung ermöglicht wird.

Erfindungsgemäß wird diese Aufgabe durch die Merkmale der Ansprüche 1, 10 und 11 gelöst.

Weitere Ausgestaltungen der Erfindung sind Gegenstand der Unteransprüche.

Erfindungsgemäß beruht das Verfahren darauf, daß in einer ersten Testsequenz alle als fehlerhaft detektierten aktiven Mikrostrukturbauelemente in einer ersten Fehlerliste aufgeführt werden, die in der ersten Fehlerliste aufgeführte Mikrostrukturbauelemente in wenigstens einer weiteren Testsequenz erneut getestet werden und die zumindest das Ergebnis der zuletzt durchgeführten Testsequenz zur Ermittlung des Gesamttestergebnisses ausgewertet wird. Dabei stellt man in der ersten Testsequenz die Testparameter so ein, daß möglichst alle fehlerhaften Mikrostrukturbauelemente detektiert werden. In den weiteren Testsequenzen werden nur die in der Fehlerliste enthaltenen Mikrostrukturbauelemente nochmals überprüft.

Selbstverständlich können auch die Ergebnisse mehrerer oder aller Testsequenzen zur Ermittlung des Gesamtergebnisses ausgewertet werden.

In einem bevorzugten Ausführungsbeispiel wird in der wenigstens einen weiteren Testsequenz nicht nur eine Fehlerbestätigung, sondern auch eine Charakterisierung des Fehlertyps des Mikrostrukturbauelements durchgeführt. Der Fehlertyp des Mikrostrukturbauelements wird dabei zweckmäßigerweise durch Veränderung der Testparameter in den weiteren Testsequenzen bestimmt.

Nachdem die Zahl der Mikrostrukturbauelemente auf einem Substrat üblicherweise im Millionenbereich liegt und die Zahl der fehlerhaften Elemente deutlich unter Tausend liegen sollte, ergibt sich für das erfindungsgemäße Verfahren eine um mindestens den Faktor Tausend kürzere Testzeit für die weiteren Testsequenzen. Es ist daher problemlos möglich, durch weitere Testsequenzen die Testzuverlässigkeit und die Fehlercharakterisierung zu verbessern, ohne dabei die Testzeit wesentlich zu erhöhen.

Weitere Ausgestaltungen und Vorteile der Erfindung werden anhand der nachfolgenden Beschreibung und der Zeichnung näher erläutert.

In den Zeichnungen zeigen
- Fig.1: eine schematische Aufsicht eines Substrats mit einer Vielzahl von Mikrostrukturbauelementen,
- Fig.2: eine schematische Schnittdarstellung längs der Linie II-II der Fig.1 und
- Fig.3: eine schematische Darstellung einer Vorrichtung zum Testen der Funktion einer Vielzahl von Mikrostrukturbauelementen.

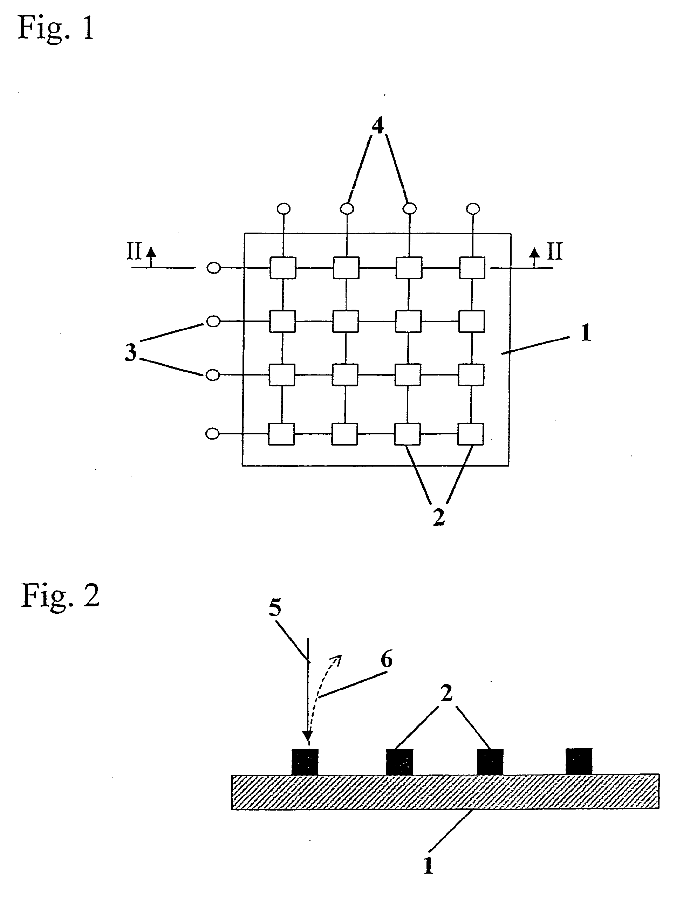

In den Figuren 1 und 2 ist ein Substrat 1 mit einer Vielzahl von Mikrostrukturbauelementen dargestellt, wobei die Mikrostrukturbauelemente 2 über Leitungen 3, 4 ansteuerbar sind.

Als Mikrostrukturbauelemente kommen beispielsweise Elemente der Mikroelektronik (wie Transistoren, Dioden, Metall-Isolator-Metall-Elemente), Bildpunktelemente und Displays, Elektronenstrukturen mikromechanischer Sensoren und Aktoren sowie Korpuskularstrahlung (beispielsweise Licht oder Elektronen) emittierende Elemente (wie Laserdioden oder Feldemissionsspitzen) in Betracht. Bei derartigen Mikrostrukturbauelementen können beispielsweise die elektrischen und/oder mechanischen Eigenschaften getestet werden. Bei bestimmten Mikrostrukturbauelementen, wie beispielsweise Laserdioden oder Feldemissionsspitzen, sind zudem Untersuchungen hinsichtlich der Emissionseigenschaften von Interesse.

Unter elektrischen Eigenschaften sind alle Eigenschaften elektronischer Elemente zu verstehen, die deren Funktion bestimmen. Dies sind insbesondere Spannungspegel, Anstieg von Schaltflanken und die zeitliche Relation verschiedener Signale in integrierten Schaltungen sowie die Ladungsspeicherung, Aufladung, Ladungsableitung und Schaltspannung bei Dünnschichttransistoren und Elementen in Flüssigkristallarrays.

Die Überprüfung mechanischer Eigenschaften wird beispielsweise an Arrays mikromechanischer Spiegel, wie sie beispielsweise für Projektionsdisplays verwendet werden, überprüft.

Unter Emissionseigenschaften sind alle Eigenschaften der Strahlung oder Korpuskeln zu verstehen, die im normalen Betrieb des Mikrostrukturbauelements emittiert werden. Dies sind beispielsweise Lichtstrom, Leuchtdichte, Strahldivergenz, usw. von Leuchtdioden und Laserdioden. Bei Elektronenemittern, die in einer Vielzahl auf einem Substrat hergestellt werden, sind beispielsweise der Elektronen-Emissionsstrom, die Stromdichte und die Elektronenenergieverteilung von Interesse.

Beim Verfahren zum Testen der Funktion einer Vielzahl von Mikrostrukturbauelementen 2 werden diese mit einem Korpuskularstrahl 5 bestrahlt. Zum Testen der Funktion gibt es prinzipiell zwei Möglichkeiten:
1. Das bestrahlte Mikrostrukturbauelement 2 wird gleichzeitig über die Leitungen 3, 4 entsprechend von außen angesteuert, so daß anhand der durch den Korpuskularstrahl am Mikrostrukturbauelement 2 ausgelösten bzw. reflektierten Sekundärkorpuskeln 6 die Eigenschaften bzw. die Funktion des Mikrostrukturbauelements ermittelt werden kann.
2. Die durch den Korpuskularstrahl 5 auf ein Mikrostrukturbauelement aufgebrachte Ladung wird über die Leitungen 3, 4 überprüft.

Anhand der Sekundärelektronen 6 bzw. die über die Leitungen 3, 4 fließenden Ströme läßt sich durch Vergleich mit Sollwerten die Funktion des Mikrostrukturbauelements überprüfen. Das Verfahren zum Testen der Funktion einer Vielzahl von Mikrostrukturbauelementen durch Bestrahlen mit einem Korpuskularstrahl sieht vor, daß zunächst in einer ersten Testsequenz alle als fehlerhaft detektierten Mikrostrukturbauelemente in einer ersten Fehlerliste aufgeführt werden, wobei die erste Testsequenz derart angelegt ist, daß dabei möglichst alle tatsächlich fehlerhaften Mikrostrukturbauelemente erfaßt werden. Alle in dieser ersten Fehlerliste aufgeführten Mikrostrukturbauelemente werden dann in wenigstens einer weiteren Testsequenz erneut getestet. Zumindest das Ergebnis der zuletzt durchgeführten Testsequenz wird zur Ermittlung des Gesamtergebnisses ausgewertet.

Nachdem die Zahl der Mikrostrukturbauelemente auf einem Substrat üblicherweise im Millionenbereich liegt und die Zahl der fehlerhaften Elemente deutlich unter Tausend liegen sollte, ergibt dieses Verfahren eine um mindestens den Faktor Tausend kürzere Testzeit für die weiteren Testsequenzen im Vergleich zum wiederholten Test aller Elemente. Es ist daher problemlos möglich, mehrere Testsequenzen zur weiteren Verbesserung der Testzuverlässigkeit und der Fehlercharakterisierung durchzuführen, ohne die Testzeit wesentlich zu erhöhen.

Nachdem die erste Testsequenz so ausgelegt ist, daß in jedem Fall alle fehlerhaften Mikrostrukturbauelemente detektiert werden, bedeutet dies natürlich, daß man dabei auch einige Mikrostrukturbauelemente fälschlicherweise als fehlerhaft einstuft. Diese falsche Einstufung kann jedoch in der weiteren bzw. den weiteren Testsequenzen korrigiert werden.

Bei der Prüfung der elektrischen Eigenschaften von Mikrostrukturbauelementen können beispielsweise interne Signale in einem Mikrostrukturbauelement auf dem Substrat überprüft werden, die sich im Betrieb über die externen Anschlüsse (Leitungen 3, 4) oder durch Simulation mit dem Korpuskularstrahl ergeben, so daß defekte Schaltungen ausgesondert werden können. Die wiederholten Messungen einer in der ersten Messung vom Sollwert abweichenden Größe muß die Ergebnisse der ersten Messung bestätigen, um eine zuverlässige Fehleraussage zu liefern. Die Charakterisierung des Fehlers kann dabei dadurch verbessert werden, daß bei der zweiten Testsequenz und bei eventuellen weiteren Testsequenzen andere Testparameter benutzt werden. Dabei kann man beispielsweise das Mikrostrukturbauelement in den einzelnen Testsequenzen unterschiedlich elektrisch ansteuern und/oder man verwendet andere Parameter des Korpuskularstrahls in den einzelnen Testsequenzen.

So kann man bei der zweiten und weiteren Testsequenz andere Versorungsspannungen, Taktfrequenzen, Integrationszeitintervalle verwenden und gegebenenfalls auch andere Größen am defekten Mikrostrukturbauelement messen.

Mit dem Verfahren läßt sich beispielsweise die Funktion von Bildpunktelementen einer aktiven TFT-Matrix eines Flüssigkristallbildschirmes zuverlässig testen, wobei die Fehler für eine eventuelle Reparatur charakterisiert werden. Die in der ersten Testsequenz fehlerhaft detektierten Bildelemente werden dabei erneut überprüft, wodurch im einfachsten Fall bei einfacher Wiederholung der ersten Testsequenz statistisch auftretende Fehlermeldungen unterdrückt werden. Weiterhin besteht die Möglichkeit, daß in den weiteren Testsequenzen mit verschiedenen Spannungen an den Zuleitungen 3, 4 der Matrix, anderen Korpuskularstrahlpulsdauern, Korpuskularstrahlspannungen, Detektionsparametern, usw. gearbeitet wird.

Bei der Überprüfung von mechanischen Eigenschaften, beispielsweise bei mikromechanischen Spiegel-Arrays werden die einzelnen Spiegelelemente über die Leitungen 3, 4 angesteuert und in einem bestimmten Maß mechanisch ausgelenkt. Eine ungenügende Auslenkung einzelner Elemente würde zu Fehlern in der Bilderzeugung führen. Um dies überprüfen zu können, muß jedes einzelne Element überprüft werden, um die einwandfreie Funktion zu gewährleisten. Die Überprüfung erfolgt zweckmäßigerweise durch den Korpuskularstrahl, wobei die Korpuskel in Abhängigkeit von der Sollstellung des zu überprüfenden Spiegels in einem bestimmten Winkel reflektiert werden müssen. Werden die reflektierten Korpuskel vom Detektor nicht erfaßt, ist dies auf eine unzureichende Funktion bzw. Auslenkung des Spiegels zurückzuführen.

Als Korpuskularstrahl wird hierfür vorzugsweise ein Lichtstrahl verwendet. Ein in der ersten Testsequenz fehlerhaft detektiertes Spiegelelement wird dann in wenigstens einer weiteren Testsequenz überprüft. Diese Überprüfung kann beispielsweise auch mit einer anderen Ansteuerung bzw. Auslenkung des Spiegels erfolgen. Ebenso sind genauere Messungen, beispielsweise mit längerer Integrationszeit, denkbar, um verschiedene Fehlermechanismen voneinander zu unterscheiden.

Bei Arrays von Feldemissionsspitzen, wie sie beispielsweise für flache Bildschirme Verwendung finden, interessieren insbesondere die Emissionseigenschaften. Um die Fehler besser charakterisieren zu können, kann man die weiteren Testsequenzen beispielsweise mit verschiedenen Spannungen an Emittern durchführen. Defekte Emitter können dann eventuell repariert werden oder das gesamte Array wird aussortiert, um die dann unnötigen weiteren Arbeitsschritte einzusparen.

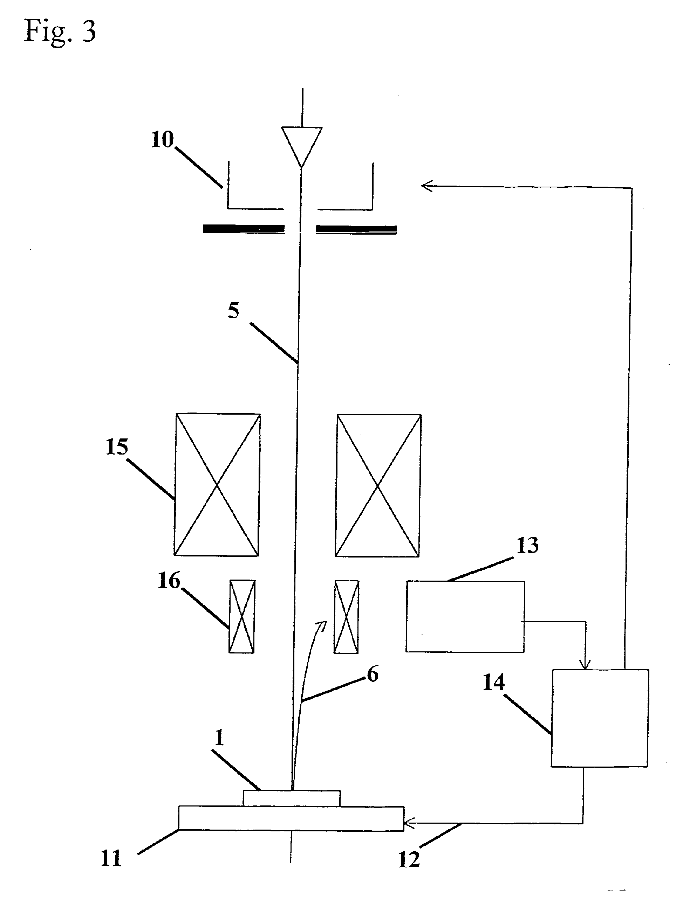

Die in Fig. 3 dargestellte Vorrichtung zum Testen der Funktion einer Vielzahl von Mikrostrukturbauelementen gemäß dem oben beschriebenen Verfahren besteht im wesentlichen aus einer Quelle 10 zur Erzeugung des Korpuskularstrahls 5, Mitteln 11 zur Aufnahme des Prüflings bzw. Substrats 1, gegebenenfalls Mitteln 12 zur Ansteuerung der Mikrostrukturbauelemente auf dem Substrat, einem Detektor 13 zum Detektieren der durch den Korpuskularstrahl 5 am Mikrostrukturbauelement emittierten bzw. reflektierten Sekundärkorpuskeln 6. Ferner sind Mittel 14 zum Auswerten der Ausgangssignale des Detektors 13 vorgesehen, wobei ein erster Datenspeicher zur Speicherung der Daten einer ersten und wenigstens einer weiteren Testsequenz vorgesehen ist. Schließlich sind Mittel zum Auswerten der Ergebnisse der Testsequenzen zur Ermittlung des Gesamttestergebnisses vorhanden. Die Mittel zum Auswerten der Ausgangssignale des Detektors, der Datenspeicher und die Mittel zur Ermittlung des Gesamttestergebnisses werden zweckmäßigerweise in einem Rechner 14 verwirklicht.

Die Quelle 10 ist beispielsweise zur Erzeugung eines Elektronenstrahls, eines Laserstrahls oder eines IonenStrahls ausgebildet. Unter Umständen ist es auch zweckmäßig, mehrere verschiedene Quellen in der Vorrichtung vorzusehen, um die Mikrostrukturbauelemente bei weiteren Testsequenzen mit einem anderen Korpuskularstrahl zu bestrahlen.

Die Vorrichtung enthält ferner alle weiteren erforderlichen und allgemein bekannten Mittel, von denen lediglich noch eine Linse 15 sowie eine Ablenkeinrichtung 16 dargestellt sind.

Das oben beschriebene Testverfahren eignet sich im besonderen Maße für ein Verfahren zur Herstellung von Mikrostrukturbauelementen, die in einer Vielzahl auf einem Substrat aufgebaut und getestet werden. Bei den Mikrostrukturbauelementen kann es sich dabei beispielsweise um Displays handeln.

Das Testverfahren kann dabei wahlweise an einem Zwischenprodukt oder an den fertig aufgebauten Mikrostrukturbauelementen durchgeführt werden.

## Patentansprüche

1. Verfahren zum Testen der Funktion einer Vielzahl von aktiven Mikrostrukturbauelementen (2) durch Bestrahlen mit einem Korpuskularstrahl (5), wobei
- in einer ersten Testsequenz alle als fehlerhaft detektierten Mikrostrukturbauelemente in einer ersten Fehlerliste aufgeführt werden, und wobei die erste Testsequenz derart angelegt ist, daß dabei möglichst alle tatsächlich fehlerhaften Mikrostrukturbauelemente erfaßt werden,
- **dadurch gekennzeichnet, daß** die in der ersten Fehlerliste aufgeführten Mikrostrukturbauelemente in wenigstens einer weiteren Testsequenz erneut getestet werden, wobei die Testparameter bei der weiteren Testsequenz verändert werden, um den Fehlertyp des Mikrostrukturbauelements zu charakterisieren
- und zumindest das Ergebnis der zuletzt durchgeführten Testsequenz zur Ermittlung des Gesamttestergebnisses ausgewertet wird.

2. Verfahren nach Anspruch 1, **dadurch gekennzeichnet, daß** in der wenigstens einen weiteren Testsequenz eine Fehlerbestätigung und eine Charakterisierung des Fehlertyps des Mikrostrukturbauelements durchgeführt wird.

3. Verfahren nach Anspruch 1, **dadurch gekennzeichnet, daß** bei jedem Mikrostrukturbauelement die durch den Korpuskularstrahl am Mikrostrukturbauelement emittierten bzw. reflektierten Korpuskel detektiert und ausgewertet werden.

4. Verfahren nach Anspruch 3, **dadurch gekennzeichnet, daß** die während einer bestimmten Testsequenz bei der Auswertung der detektierten Korpuskel als fehlerhaft festgestellten Mikrostrukturbauelemente in die zur Testsequenz gehörenden Fehlerliste aufgenommen werden.

5. Verfahren nach Anspruch 1, **dadurch gekennzeichnet, daß** die Mikrostrukturbauelemente während der Testsequenzen elektrisch angesteuert werden.

6. Verfahren nach Anspruch 1, **dadurch gekennzeichnet, daß** die elektrische Ansteuerung der Mikrostrukturbauelemente in den einzelnen Testsequenzen unterschiedlich ist.

7. Verfahren nach Anspruch 1, **dadurch gekennzeichnet, daß** die Parameter des Korpuskularstrahls (5) bei jeder weiteren Testsequenz verändert werden.

8. Verfahren nach Anspruch 7, **dadurch gekennzeichnet, daß** die Energie und/oder die Strahlanzeiten des Korpuskularstrahls verändert werden.

9. Verfahren nach einem oder mehreren der vorhergehenden Ansprüche, **dadurch gekennzeichnet, daß** die Ergebnisse aller Testsequenzen zur Ermittlung des Gesamttestergebnisses ausgewertet werden.

10. Vorrichtung zum Testen der Funktion einer Vielzahl von Mikrostrukturbauelementen (2) gemäß dem Verfahren nach einem der Ansprüche 1 bis 9, enthaltend
a) eine Quelle (10) zur Erzeugung eines Korpuskularstrahls,
b) Mittel (11) zur Aufnahme eines Substrats (1) mit einer Vielzahl von Mikrostrukturbauelementen (2),
c) einen Detektor (13) zum Detektieren der durch den Korpuskularstrahl (5) am Mikrostrukturbauelement emittierten bzw. reflektierten Sekundärkorpuskels (6),
d) Mittel (14) zum Auswerten der Ausgangssignale des Detektors (13),
e) einen Datenspeicher zur Speicherung der Daten einer ersten und wenigstens einer weiteren Testsequenz
f) und Mittel zum Auswerten der Ergebnisse aller Testsequenzen zur Ermittlung eines Gesamttestergebnisses.

11. Verfahren zur Herstellung von Mikrostrukturbauelementen (2), die in einer Vielzahl auf einem Substrat aufgebaut und getestet werden,
**dadurch gekennzeichnet, daß** das Testverfahren nach einem oder mehreren der Ansprüche 1 bis 9 abläuft.

12. Verfahren nach Anspruch 11, **dadurch gekennzeichnet, daß** das Testverfahren an dem fertig aufgebauten Mikrostrukturbauelement durchgeführt wird.

13. Verfahren nach Anspruch 12, **dadurch gekennzeichnet, daß** das Testverfahren an einem Zwischenprodukt des Mikrostrukturbauelements durchgeführt wird.

14. Verfahren nach einem der Ansprüche 11 bis 13, **dadurch gekennzeichnet, daß** es sich bei den Mikrostrukturbauelementen um Displays handelt.

## Claims

1. Method for testing the function of a plurality of active microstructural elements (2) by irradiation with particle radiation (5), wherein
- all of the microstructural elements detected as malfunctioning are listed in a first error list in a first test sequence, and wherein the first test sequence being designed so that, if possible, all of the microstructural elements that are de facto malfunctioning are detected,
**characterized in that**
- the microstructural elements listed in the first error list are re-tested in at least one further test sequence, whereby the test parameters are modified for the further test sequence to characterize the error type of the microstructural element,
- and at least the result of the test sequence last carried out is evaluated to establish the overall test result.

2. Method according to claim 1, **characterized in that**, in the at least one further test sequence, an error confirmation and a characterization of the error type of the microstructural element are carried out.

3. Method according to claim 1, **characterized in that**, for each microstructural element, the corpuscles which are emitted or reflected at the microstructural element by the particle radiation are detected and evaluated.

4. Method according to claim 3, **characterized in that** the microstructural elements which are detected as malfunctioning during a specific test sequence when the corpuscles detected are evaluated are included in the error list which belongs to the test sequence.

5. Method according to claim 1, **characterized in that** the microstructural elements are electrically controlled during the test sequences.

6. Method according to claim 1, **characterized in that** the electrical control of the microstructural elements is different in the individual test sequences.

7. Method according to claim 1, **characterized in that** the parameters for the particle radiation (5) are changed for every further test sequence.

8. Method according to claim 7, **characterized in that** the energy and/or the emission times of the particle radiation are changed.

9. Method according to one or more of the preceding claims, **characterized in that** the results of all of the test sequences are evaluated to establish the overall test result.

10. Apparatus for testing the function of a plurality of microstructural elements (2) in accordance with the method according to any one of claims 1 to 9, comprising
a) a source (10) for generating particle radiation,
b) means (11) for receiving a substrate (1) having a plurality of microstructural elements (2),
c) a detector (13) for detecting the secondary corpuscles (6) which are emitted or reflected at the microstructural element by the particle radiation (5),
d) means (14) for evaluating the output signals of the detector (13),
e) a data store for storing the data of a first and at least one further test sequence,
f) and means for evaluating the results of all of the test sequences to establish an overall test result.

11. Method for producing microstructural elements (2) which are constructed and tested as a plurality on a substrate, **characterized in that** the test method is effected according to one or more of claims 1 to 9.

12. Method according to claim 11, **characterized in that** the test method is effected on the completely constructed microstructural element.

13. Method according to claim 11, **characterized in that** the test method is effected on an intermediate product of the microstructural element.

14. Method according to claim 11 to 13, **characterized in that** the microstructural elements are displays.

## Revendications

1. Procédé de test du fonctionnement de plusieurs éléments de microstructure actifs (2) par irradiation avec un rayonnement corpusculaire (5), dans lequel
- dans une première séquence de test, tous les éléments de microstructure détectés comme étant défectueux sont mentionnés dans une première liste d'erreurs, et dans lequel la première séquence de test est appliquée de façon telle que le plus possible des éléments de microstructure réellement défectueux sont recensés,
**caractérisé en ce que**
- les éléments de microstructure mentionnés dans la première liste d'erreurs sont à nouveau testés dans au moins une autre séquence de test, les paramètres de test étant modifiés dans l'autre séquence de test pour caractériser le type d'erreur de l'élément de microstructure,
- et au moins le résultat de la séquence de test réalisée en dernier est évalué pour déterminer le résultat total du test.

2. Procédé selon la revendication 1, **caractérisé en ce que**, dans l'autre séquence de test, au moins au nombre de une, on réalise une confirmation d'erreur et une caractérisation du type d'erreur de l'élément de microstructure.

3. Procédé selon la revendication 1, **caractérisé en ce que**, pour chaque élément de microstructure, les corpuscules émis ou réfléchis par le rayonnement corpusculaire sur l'élément de microstructure sont détectés et évalués.

4. Procédé selon la revendication 3, **caractérisé en ce que** les éléments de microstructure constatés comme défectueux pendant une séquence de test déterminée, lors de l'évaluation des corpuscules détectés, sont recensés dans la liste d'erreur se rapportant à la séquence de test.

5. Procédé selon la revendication 1, **caractérisé en ce que** les éléments de microstructure, pendant les séquences de test, sont adressés par voie électrique.

6. Procédé selon la revendication 1, **caractérisé en ce que** l'adressage électrique des éléments de microstructure est différent dans les différentes séquences de test.

7. Procédé selon la revendication 1, **caractérisé en ce que** les paramètres du rayonnement corpusculaire (5) sont modifiés à chaque autre séquence de test.

8. Procédé selon la revendication 7, **caractérisé en ce que** l'énergie et/ou les durées d'irradiation du rayonnement corpusculaire sont modifiées.

9. Procédé selon une ou plusieurs des revendications précédentes, **caractérisé en ce que** les résultats de toutes les séquences de test sont évalués pour déterminer le résultat total du test.

10. Dispositif de test du fonctionnement de plusieurs éléments de microstructure (2) selon le procédé selon l'une des revendications 1 à 9, contenant
a) une source (10) permettant de générer un rayonnement corpusculaire,
b) des moyens (11) permettant de recevoir un substrat (1) comportant plusieurs éléments de microstructure (2),
c) un détecteur (13) permettant de détecter le corpuscule secondaire (6) émis ou réfléchi sur l'élément de microstructure par le rayonnement corpusculaire (5),
d) des moyens (14) permettant d'évaluer les signaux de sortie du détecteur (13),
e) une mémoire de données permettant de mémoriser les données d'une première et d'au moins une autre séquences de test, et
f) des moyens permettant d'évaluer les résultats de toutes les séquences de test pour déterminer un résultat total de test.

11. Procédé de fabrication d'éléments de microstructure (2) qui sont en nombre montés et testés sur un substrat,
**caractérisé en ce que** le procédé de test se déroule selon une ou plusieurs des revendications 1 à 9.

12. Procédé selon la revendication 11, **caractérisé en ce que** le procédé de test est réalisé sur l'élément de microstructure monté fini.

13. Procédé selon la revendication 11 **caractérisé en ce que** le procédé de test est réalisé sur un produit intermédiaire de l'élément de microstructure.

14. Procédé selon l'une des revendications 11 à 13, **caractérisé en ce qu'**il s'agit, concernant les éléments de microstructure, d'afficheurs.
